# EUROPÄISCHE PATENTANMELDUNG

(11) **EP 1 494 279 A1**
(43) Veröffentlichungstag der Anmeldung: **05.01.2005**
(21) Anmeldenummer: 03015104.7
(22) Anmeldetag: 03.07.2003
(51) Int. Cl.: H01L 23/48, H01L 23/051, H01L 23/367, H01L 23/433

(54) **Kühlende flexible Kontaktvorrichtung für einen Halbleiterchip**

(71) Anmelder: SIEMENS AKTIENGESELLSCHAFT, 80333 München (DE)
(72) Erfinder: Kreutzer, Rainer, 92637 Weiden (DE)

(57) **Zusammenfassung**

Die Entwärmung eines Halbleiterleistungsmoduls soll verbessert werden. Hierzu ist eine Kontakteinrichtung (3) für einen Halbleiterchip vorgesehen, die eine Basiskontakteinrichtung (4), die unmittelbar auf dem Halbleiterchip zur elektrischen Kontaktierung und Wärmeableitung montiert ist und eine Anschlusseinrichtung (8), die mit der Basiskontakteinrichtung (4) elektrisch und wärmeleitend verbunden ist, aufweist, so dass der größte Teil des Wärmeabtransports von dem Halbleiterchip (1) über die Kontakteinrichtung (3) erfolgt. Dabei ist zwischen die Basiskontakteinrichtung (4) und die Anschlusseinrichtung (8) elektrisch und wärmeleitend eine Leitereinrichtung (6) geschaltet, die eine Übertragung von Kräften und Drehmomenten von der Anschlusseinrichtung (8) zu der Basiskontakteinrichtung (4) im Wesentlichen verhindert. Somit kann ein Wärmeabtransport über die elektrische Kontaktvorrichtung (3) ohne die Gefahr des Bruches des Chips (1) oder Substrats (2) beim elektrischen Anschließen erfolgen.

## Beschreibung

Die vorliegende Erfindung betrifft eine Kontaktvorrichtung für einen Halbleiterchip mit einer Basiskontakteinrichtung, die unmittelbar mit dem Halbleiterchip zur elektrischen Kontaktierung und Wärmeableitung verbindbar ist, und einer Anschlusseinrichtung, die mit der Basiskontakteinrichtung elektrisch und wärmeleitend verbunden ist, so dass der größte Teil des Wärmeabtransports von dem Halbleiterchip über die Anschlusseinrichtung erfolgt. Darüber hinaus betrifft die vorliegende Erfindung ein entsprechendes Verfahren zum Kühlen des Halbleiterchips.

Bei stromdurchflossenen Halbleiterleistungsschaltelementen oder -modulen mit diversen Halbleiterbauelementen (z. B. Si-Thyristoren oder Si-IGBT) besteht im Allgemeinen die Notwendigkeit der Kühlung beziehungsweise Entwärmung des Halbleiterchips zum Schutz vor thermischer Zerstörung. Die Abführung der Verlustwärme erfolgt in der Regel hauptsächlich über die auf ein DCB-Substrat (direct copper bonding) gelötete Chipunterseite durch das DCB-Substrat hindurch über einen dort angebrachten Kühlkörper. Die vom Halbleiter abführbare Verlust-Wärmemenge bestimmt unter anderem wesentlich die Leistungsklasse dieses Schaltelements und sollte somit bei kleinen Außenabmessungen der Module so groß wie möglich sein.

Des Weiteren weisen Halbleiter-Leistungsmodule Anschlussklemmen für Stromleiter auf. Diese Anschlussklemmen dienen einerseits zum elektrischen Kontaktieren des Halbleiterchips und müssen andererseits die Anschließkräfte (z. B. Schraubenanzugmomente bei Schraubklemmen) und dergleichen aufnehmen. Aus Gründen der Zerstörungsgefahr ist es beim Anschließen von Leitungen an die Anschlussklemmen jedoch wichtig, dass keinerlei Kraft auf die Halbleiter ausgeübt wird. Im Übrigen ist die zulässige Krafteinleitung in das DCB-Substrat ebenfalls beschränkt.

Halbleiterleistungsmodule, speziell im kleineren Leistungsbereich, weisen heute üblicherweise eine Aufbautechnik auf, bei der - wie erwähnt - die Chipunterseite auf einen Träger (DCB-Substrat mit elektrisch leitender Cu-Schicht) gelötet wird. Diese Cu-Schicht stellt gleichzeitig eine elektrische Verbindung zur Chipunterseite her, über die auch im Wesentlichen die Entwärmung erfolgt. Die Chipoberseite weist lediglich Kontaktierelemente (Bonddrähte) zur elektrischen Verbindung mit Flächen auf dem DCB-Substrat auf. Diese Kontaktierelemente leisten aber aufgrund des kleinen Querschnitts keinen nennenswerten Beitrag zur Halbleiterkühlung. Somit kann die Chipoberseite nicht zur Entwärmung herangezogen werden. Ein derartiges Leistungshalbleitermodul ist aus dem Dokument DE 199 14 741 bekannt.

Bei anderen Aufbauvarianten wird anstelle der Bonddrähte ein gebogenes Blechteil aufgelötet und stellt so die elektrische Verbindung von der Chipoberseite zu dem DCB-Schaltungslayout dar. Auch hier dient diese Verbindung nicht zur Halbleiterkühlung, sondern zur elektrischen Verbindung.

Die Befestigung der Anschlussklemmen erfolgt entweder durch Löten der Klemmen auf die DCB-Cu-Schicht oder durch Befestigen der Klemmenteile im Modulgehäuse und Bonden vom jeweiligen Anschluss zu der DCB-Cu-Schicht. So wird zwar eine elektrische Verbindung hergestellt und eine Kraftentkopplung zwischen Klemme und Halbleiterchip erreicht, aber eine nennenswerte zusätzliche Wärmeabfuhr beziehungsweise Chipkühlung durch die Anschlussklemme in den angeschlossenen Leiter oder an die Umgebung erfolgt nicht. Weiterhin sind mehrere Aufbauvarianten von Halbleiterleistungsmodulen bekannt, bei denen der Halbleiter zwischen zwei Druckelementen eingespannt, d. h. nicht gelötet, ist. Derartige Module, die auch als Druckkontaktmodule bezeichnet werden, sind aus den Dokumenten DE 100 48 859 und EP 0 169 356 bekannt. Hier findet zwar eine beidseitige Chipentwärmung bei gleichzeitiger elektrischer Kontaktierung statt, aber die dazu benötigte Druckmechanik ist aufwändig und es ergibt sich ein relativ hohes Bauvolumen.

Die Aufgabe der vorliegenden Erfindung besteht somit darin, in einem Halbleiterleistungsmodul eine verbesserte Entwärmung bei geringem Bauvolumen zu gewährleisten.

Erfindungsgemäß wird diese Aufgabe gelöst durch eine Kontaktvorrichtung für einen Halbleiterchip mit einer Basiskontakteinrichtung, die unmittelbar mit dem Halbleiterchip zur elektrischen Kontaktierung und Wärmeableitung verbindbar ist, und einer Anschlusseinrichtung, die mit der Basiskontakteinrichtung elektrisch und wärmeleitend verbunden ist, so dass der größte Teil des Wärmeabtransports von dem Halbleiterchip über die Anschlusseinrichtung erfolgt, wobei zwischen die Basiskontakteinrichtung und die Anschlusseinrichtung elektrisch und wärmeleitend eine Leitereinrichtung geschaltet ist, die eine Übertragung von Kräften und Drehmomenten von der Anschlusseinrichtung zu der Basiskontakteinrichtung im Wesentlichen verhindert.

Darüber hinaus wird erfindungsgemäß bereitgestellt ein Verfahren zum Kühlen eines Halbleiterchips durch Ableiten des größten Teils der Wärme von dem Halbleiterchip mittels einer Basiskontakteinrichtung, die unmittelbar mit dem Halbleiterchip zur elektrischen Kontaktierung und Wärmeableitung verbunden ist, und Ableiten der Wärme von der Basiskontakteinrichtung durch eine elektrisch leitfähige Leitereinrichtung, die eine Übertragung von Kräften und Drehmomenten von der Anschlusseinrichtung zu der Basiskontakteinrichtung im Wesentlichen verhindert, zu einer elektrischen Anschlusseinrichtung.

Erfindungsgemäß wird damit erreicht, unter Beachtung der Wechsellastproblematik der Verbindung zwischen dem Halbleiterchip und dem Chipkontaktanschluss einerseits gute Wärmeableitung von der Chipoberseite über möglichst große Materialquerschnitte und kurze Wärmeleitwege bei entsprechender Wärmeabfuhr an die Umgebung zu gewährleisten und andererseits bei kleinem Bauvolumen die Klemme mechanisch von den elektrischen Bauelementen zu entkoppeln.

Vorzugsweise weist die Basiskontakteinrichtung ein Chipkontaktflächenelement, mit dem im Wesentlichen eine gesamte Seite des Halbleiterchips abdeckbar ist, und mindestens ein Anbindungselement zum Kontaktieren der Leitereinrichtung auf. Damit kann beispielsweise von der Chipoberseite großflächig wärme abgeleitet werden.

Es ist günstig, wenn die Basiskontakteinrichtung aus einem Material, insbesondere Invar, Mo oder MoCu, besteht, dessen Wärmeausdehnungskoeffizient im Wesentlichen dem des Halbleiterchips entspricht. Dadurch wird vermieden, dass der Halbleiterchip Kräften ausgesetzt wird, die sich aufgrund unterschiedlicher Ausdehnungen bei Wärme ergeben würden, wenn der Chip beispielsweise durch Löten fest mit der Basiskontakteinrichtung verbunden ist.

Die Leitereinrichtung, die flexibel ausgestaltet ist, kann eine Litze und/oder ein Metallband umfassen. Beide sind dabei so dimensioniert, dass sie nahezu keine Kräfte auf den Halbleiterchip übertragen. Zur besseren Entwärmung an die Umgebung können mit dem Metallband Kühlrippen ausgeformt sein.

Die Basiskontakteinrichtung kann mit der Leitereinrichtung einteilig gebildet sein. Dies hätte den Vorteil, dass es keine Wärmeübergangswiderstände an dieser Stelle gäbe.

Die Anschlusseinrichtung kann ein oder mehrere Abstützelemente zum Abstützen an einem Gehäuse eines Halbleiterleistungsmoduls besitzen. Dadurch können die Kräfte, die beim Anschließen an elektrische Leiter auftreten, unmittelbar an das Gehäuse übertragen werden.

Die vorliegende Erfindung wird nun anhand der beigefügten Zeichnungen näher erläutert, in denen zeigen:
- FIG 1: eine perspektivische Ansicht auf ein Substrat und eine erfindungsgemäße Kontaktvorrichtung;
- FIG 2: eine perspektivische Ansicht auf ein Substrat mit darauf montierter Kontaktvorrichtung;
- FIG 3: eine erfindungsgemäße Kontaktvorrichtung;
- FIG 4: eine erfindungsgemäße Leitereinrichtung;
- FIG 5: eine Basiskontakteinrichtung;
- FIG 6: eine alternative Leitereinrichtung;
- FIG 7: eine abgewandelte erfindungsgemäße Kontaktvorrichtung;
- FIG 8: eine Anschlusseinrichtung; und
- FIG 9: eine perspektivische Ansicht eines Halbleitersubstrats mit der Kontaktvorrichtung gemäß FIG 2, wie sie in ein Gehäuse montiert ist.

Die nachfolgend näher beschriebenen Ausführungsformen stellen bevorzugte Ausführungsbeispiele der vorliegenden Erfindung dar.

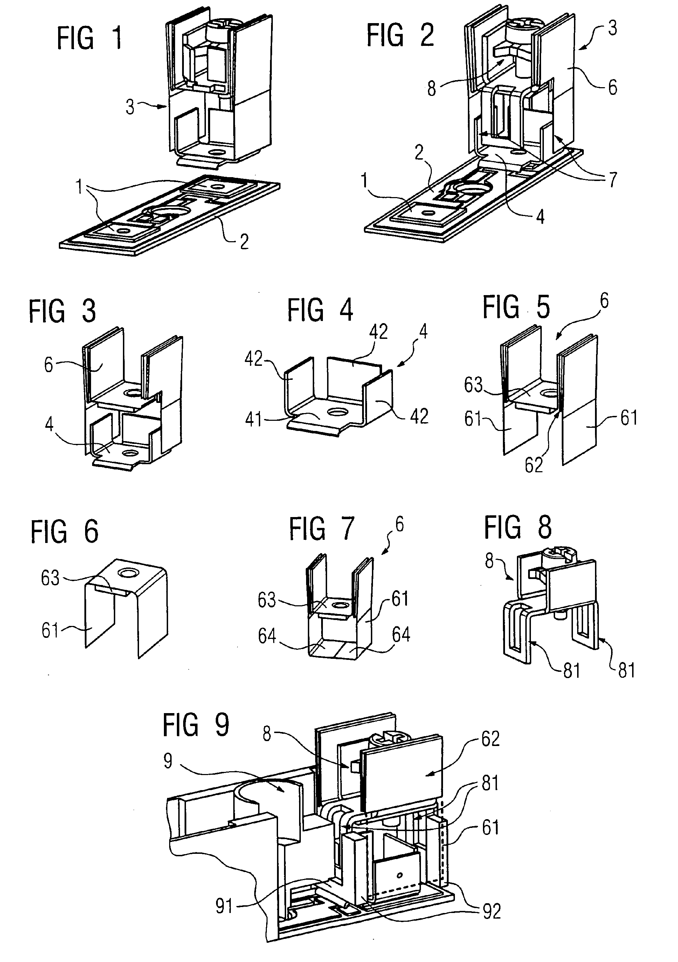

Die Kühlung eines Halbleiterchips 1 auf einem DCB-Substrat 2 kann durch eine Kontaktvorrichtung 3 erfolgen, die gemäß FIG 1 auf die Chipoberseite montiert wird. Die Kontakteinrichtung 3 dient primär zum elektrischen Kontaktieren des jeweiligen Halbleiterchips 1 und wird gleichzeitig zur Wärmeableitung von dem Halbleiterchip 1 über Anschlussklemmen nach außen verwendet.

FIG 2 zeigt den Zustand, in dem die Kontaktvorrichtung 3 einschließlich einer Basiskontakteinrichtung 4, einer Leitereinrichtung 6 und einer Anschlusseinrichtung 8 auf einem der Halbleiterchips 1 beispielsweise durch Löten aufgebracht ist. Dabei dient die in FIG 4 einzeln dargestellte Basiskontakteinrichtung 4 als Kontaktierelement, das direkt auf dem Halbleiterchip 1 aufsitzt beziehungsweise auf diesen gelötet ist. Aufgrund dieser starren Verbindung muss die Basiskontakteinrichtung 4 frei von Krafteinflüssen, z. B. Anschraubdrehmomente, Druckkräfte, Torsionskräfte oder dergleichen, die bei einer Leiterklemmung auftreten, sein, da der Halbleiterchip 1 sehr kraftempfindlich ist.

In FIG 3 ist die Kontaktvorrichtung 3 ohne die Anschlusseinrichtung 8, die im Zusammenhang mit FIG 8 näher beschrieben werden wird, dargestellt. Auf die Basiskontakteinrichtung beziehungsweise Kontaktiereinrichtung 4 ist die Leitereinrichtung 6 montiert. Die Verbindung zwischen beiden Elementen erfolgt möglichst großflächig, so dass ein guter Wärmeübergang garantiert werden kann. Im vorliegenden Fall werden hierzu zwei Flächenelemente für jede Kontaktstelle aneinandergelötet.

Das Kontaktierelement 4 ist in FIG 4 einzeln dargestellt. Es besitzt ein Chipkontaktflächenelement 41, mit dem die elektrische Kontaktierung des Halbleiterchips 1 und dessen unmittelbare Wärmeableitung durchgeführt wird. Darüber hinaus besitzt das Kontaktierelement 4 Anbindungselemente 42, die flächig ausgebildet sind und senkrecht an die Seiten des rechteckig ausgebildeten Chipkontaktflächenelements 41 angeformt sind. In dem Beispiel von FIG 4 besitzt die Basiskontakteinrichtung 4 drei dieser Anbindungselemente 42. Deren Anzahl kann aber auch 1, 2, 4 usw. betragen. Ebenso kann das Chipkontaktflächenelement 41 auch eine andere Gestalt als die rechteckförmige aufweisen.

Die Basiskontakteinrichtung beziehungsweise das Kontaktierelement 4 dient in erster Linie als Adapter zur Anpassung der thermischen Ausdehnungskoeffizienten. Wird auf einen derartigen Adapter verzichtet, so kann es zu unzulässigen Spannungen in dem Halbleiterchip 1 beim Ableiten der Wärme durch einen fest aufgebrachten Körper beispielsweise aus Kupfer kommen. Wird ein geeignetes Material für das Kontaktierelement 4 mit einem an Silizium angepassten Wärmeausdehnungskoeffizienten verwendet, ergeben sich auch hinsichtlich der bekannten Temperatur-/Lastwechselproblematik keine Lebensdauerprobleme der Lötverbindung zum Chip 1. Ein derartiges Material wäre beispielsweise eine Eisen-Nickel-Legierung mit dünner Kupferschicht, bekannt unter dem Namen "Invar". Dieses Material besitzt jedoch eine geringere Leitfähigkeit als reines, massives Kupfer. Aus diesem Grund wird mit diesem Formteil 4 ein flexibles Kupferband 6 als guter Wärmeleiter großflächig und fest verbunden. Diesbezüglich Verbindungsstellen sind in FIG 2 mit den Pfeilen 7 angedeutet. Sie stellen üblicherweise Lötverbindungen dar.

In FIG 5 ist die Leitereinrichtung 6 separat dargestellt. Sie besteht im Wesentlichen aus einem flexiblen Kupferband. Zwei Seitenabschnitte 61 und 62 dienen zum Anlöten an die Anbindungselemente 42 des Kontaktierelements 4. In Verlängerung an die Seitenelemente 61 sind Kühlrippen beziehungsweise Lamellen 62 aus dem Kupferband geformt. Damit ergibt sich ein H-förmiges Gebilde. Der Mittelsteg dieses H-förmig gefalteten Kupferbands verfügt ferner über ein beispielsweise angelötetes Gewindegegenstück 63, das ein Teil einer Anschlussschraubklemme darstellt.

Die Faltung des Kupferbands zwischen dem Steg 63 und den Seitenabschnitten 61 in mehreren Schleifen dient darüber hinaus zur Erhöhung der mechanischen Flexibilität der Verbindung des Halbleiterchips 1 und der Anschlussklemme 8 im montierten Zustand.

Eine alternative Ausführungsform der Leitereinrichtung 6 von FIG 5 ist in FIG 6 dargestellt. Dabei ist auf die gefalteten Lamellen 62 verzichtet.

Eine weitere Ausführungsform der Leitereinrichtung 6 ist in FIG 7 wiedergegeben. Diese Ausführungsform basiert auf der von FIG 5, wobei die unteren Schenkel 61 des H-förmigen Gebildes jeweils nach innen weisende, parallel zum Mittelsteg 63 verlaufende Fortsätze 64 aufweisen. Diese Fortsätze können einerseits dazu verwendet werden, die Leitereinrichtung 6 direkt, d. h. ohne das Kontaktierelement 4 auf den Halbleiterchip 1 zu montieren oder andererseits die Fläche des Kupferbands, die mit dem Kontaktierelement 4 - falls es dennoch verwendet wird -in Berührung steht, zu vergrößern.

FIG 8 zeigt eine Anschlusseinrichtung 8, die gemäß FIG 1 oder 2 in die Leitereinrichtung von FIG 3 bis 7 eingesetzt wird. Die Anschlusseinrichtung 8 ist als Schraubklemme mit Stützen 81 realisiert. Diese dienen zum Abstützen der Klemme 8 in einem Gehäuse 9 eines Halbleiterleistungsmoduls, wie dies in FIG 9 dargestellt ist. Die Abstützelemente 81 sind dabei vertikal auf entsprechende Vorsprünge 91 abgestützt. Darüber hinaus sind Nasen 92 des Gehäuses 9 dazu verwendet, eine Drehbewegung der Anschlusseinrichtung 8 an den Abstützeinrichtungen 81 zu verhindern. Somit werden Klemmenbetätigungskräfte beziehungsweise -drehmomente unmittelbar an dem Gehäuse 9 abgestützt, ohne auf das DCB-Substrat 2 beziehungsweise den Halbleiterchip 1 zu wirken, so dass Brüche vermieden werden können.

Die Leitereinrichtung 6 kann in dem Gehäuse 9 so angeordnet werden, dass die speziell gefalteten Kühllamellen beziehungsweise Kühlfahnen 62 über das Gehäuse ragen und somit eine verbesserte Wärmeübertragung an die Umgebungsluft sicherstellen.

Das Seitenelement 61 ist in FIG 9 lediglich durch gestrichelte Linie angedeutet. Darüber hinaus sind zur Verdeutlichung des Aufbaus die Elemente 61 und 62 in den FIG 2 und 3 teilweise ausgebrochen.

Mit dem erfindungsgemäßen Aufbau wird eine flexible aber dennoch gut wärmeleitende elektrische Verbindung mittels Kupferoder Aluminiumband, die eine Kraftentkopplung zwischen Schraubebene (Krafteinleitungsebene) und Chipebene (Halbleiterebene) gewährleistet, bereitgestellt.

## Patentansprüche

1. Kontaktvorrichtung für einen Halbleiterchip (1) mit
- einer Basiskontakteinrichtung (4, 64), die unmittelbar mit dem Halbleiterchip (1) zur elektrischen Kontaktierung und Wärmeableitung verbindbar ist, und
- einer Anschlusseinrichtung (8), die mit der Basiskontakteinrichtung (4, 64) elektrisch und wärmeleitend verbunden ist, so dass der größte Teil des Wärmeabtransports von dem Halbleiterchip (1) über die Anschlusseinrichtung (8) erfolgt,
**dadurch gekennzeichnet, dass**
- zwischen die Basiskontakteinrichtung (4, 64) und die Anschlusseinrichtung (8) elektrisch und wärmeleitend eine Leitereinrichtung (6) geschaltet ist, die eine Übertragung von Kräften und Drehmomenten von der Anschlusseinrichtung (8) zu der Basiskontakteinrichtung (4, 64) im Wesentlichen verhindert.

2. Kontaktvorrichtung nach Anspruch 1, wobei die Basiskontakteinrichtung (4) ein Chipkontaktflächenelement (41), mit dem im Wesentlichen eine gesamte Seite des Halbleiterchips (1) abdeckbar ist, und mindestens ein Anbindungselement (42) zum Kontaktieren der Leitereinrichtung (6) aufweist.

3. Kontaktvorrichtung nach Anspruch 1 oder 2, wobei die Basiskontakteinrichtung (4) aus einem Material, insbesondere Invar, besteht, dessen Wärmeausdehnungskoeffizient im Wesentlichen dem des Halbleiterchips (1) entspricht.

4. Kontaktvorrichtung nach einem der vorhergehenden Ansprüche, wobei die Leitereinrichtung (6) eine Litze umfasst.

5. Kontaktvorrichtung nach einem der vorhergehenden Ansprüche, wobei die Leitereinrichtung (6) ein Metallband umfasst.

6. Kontaktvorrichtung nach Anspruch 5, wobei mit dem Metallband Kühlrippen (62) ausgeformt sind.

7. Kontaktvorrichtung nach Anspruch 5 oder 6, wobei die Basiskontakteinrichtung (64) mit der Leitereinrichtung (6) einteilig gebildet ist.

8. Kontaktvorrichtung nach einem der vorhergehenden Ansprüche, wobei die Anschlusseinrichtung (8) ein oder mehrere Abstützelemente (81) zum Abstützen an einem Gehäuse (9) eines Halbleiterleistungsmoduls besitzt.

9. Halbleiterleistungsmodul mit einem Halbleiterchip (1) und einer Kontaktvorrichtung (3) nach einem der vorhergehenden Ansprüche.

10. Verfahren zum Kühlen eines Halbleiterchips (1) durch
- Ableiten des größten Teils der Wärme von dem Halbleiterchip (1) mittels einer Basiskontakteinrichtung (4, 64), die unmittelbar mit dem Halbleiterchip (1) zur elektrischen Kontaktierung und Wärmeableitung verbunden ist, und
- Ableiten der Wärme von der Basiskontakteinrichtung (4, 64) durch eine elektrisch leitfähige Leitereinrichtung (6), die eine Übertragung von Kräften und Drehmomenten von der Anschlusseinrichtung zu der Basiskontakteinrichtung (4, 64) im Wesentlichen verhindert, zu einer elektrischen Anschlusseinrichtung (8).
